# EUROPEAN PATENT APPLICATION

(11) **EP 4 712 705 A1**
(43) Date of publication of application: **18.03.2026**
(21) Application number: 25200388.4
(22) Date of filing: 05.09.2025
(51) Int. Cl.: H05K 1/02, H01P 3/12, H05K 1/11, H10W 44/20

(54) **DEVICES INCLUDING SUBSTRATE STRUCTURE WITH LATERALLY OFFSET GROUND VIAS AND METAL BALLS**

(30) Priority: 11.09.2024 US 202463693262 P; 25.08.2025 US 202519309483
(71) Applicant: MEDIATEK INC., Hsinchu City 30078 (TW)
(72) Inventor: LIAO, Ching-Ku, 30078 Hsinchu City (TW); TSAI, Cheng-Wei, 30078 Hsinchu City (TW)
(74) Representative: Haseltine Lake Kempner LLP

(57) **Abstract**

Devices including a substrate structure with laterally offset ground vias and metal balls are provided. A device may include a substrate, a plurality of first ground vias, and a plurality of first metal balls. The plurality of first ground vias may be formed within the substrate and surrounding a plurality of signal vias. The plurality of first metal balls may be disposed on the substrate and electrically coupled to the plurality of first ground vias. One first metal ball may be electrically coupled to one first ground via. A part of the plurality of first ground vias may be laterally offset from a corresponding part of the plurality of first metal balls along a direction orthogonal to the substrate.

## Description

### CROSS REFERENCE TO RELATED PATENT APPLICATION(S)

The present disclosure is part of a non-provisional application claiming the priority benefit of U.S. Patent Application No. 63/693,262, filed 11 September 2024, the content of which herein being incorporated by reference in its entirety.

### TECHNICAL FIELD

The present disclosure is generally related to a device and, more particularly, to a Printed Circuit Board (PCB) associated device.

### BACKGROUND

Unless otherwise indicated herein, approaches described in this section are not prior art to the claims listed below and are not admitted as prior art by inclusion in this section.

High-speed interconnects in semiconductor packaging are increasingly constrained by physical structural limitations, for example, in Ball Grid Array (BGA) packages that rely on metal balls and vertical vias to transmit high-frequency signals between Integrated Circuit (IC) dies and Printed Circuit Boards (PCBs). As signaling rates in serial interfaces such as SerDes exceed 224 Gbps and even 400 Gbps, signal integrity becomes highly sensitive to electromagnetic phenomena associated with interconnect geometry.

In conventional packaging structures, when the operating frequency exceeds a certain threshold (referred to as the cut-off frequency), higher-order electromagnetic modes may be excited within the package. These higher-order modes may propagate both within the package and into the PCB region, resulting in unwanted resonance effects, electromagnetic coupling, and significant signal degradation. The cut-off frequency at which such modes begin to propagate may be closely related to certain pitch dimensions (e.g., the pitch of BGA balls). As the pitch increases, the cut-off frequency decreases, thereby limiting the maximum usable frequency range and the bandwidth available for reliable high-speed signal transmission. This phenomenon becomes particularly problematic in large or high-pin-count packages, where the pitch often exceeds 0.8 millimeter (mm) or 1.0 mm, further reducing the electromagnetic confinement of the interconnect structure.

The emergence of higher-order mode propagation may disrupt intended signal paths and degrade signal integrity, especially under high-frequency operating conditions. These effects present critical challenges to achieving reliable performance in advanced semiconductor packaging systems.

### SUMMARY

The following summary is illustrative only and is not intended to be limiting in any way. That is, the following summary is provided to introduce concepts, highlights, benefits and advantages of the novel and non-obvious techniques described herein. Select implementations are further described below in the detailed description. Thus, the following summary is not intended to identify essential features of the claimed subject matter, nor is it intended for use in determining the scope of the claimed subject matter.

An objective of the present disclosure is to propose solutions or schemes that address the aforementioned issues pertaining to data transmission in high-frequency interconnect structures.

In one aspect, a device may comprise a substrate, a plurality of first ground vias and a plurality of first metal balls. The plurality of first ground vias may be formed within the substrate and surrounding a plurality of signal vias. The plurality of first metal balls may be disposed on the substrate and electrically coupled to the plurality of first ground vias. One first metal ball may be electrically coupled to one first ground via. At least one of the plurality of first ground vias may be laterally offset from at least one corresponding first metal ball along a direction orthogonal to the substrate.

In one aspect, a device may comprise a substrate, a plurality of first ground vias and a plurality of first metal balls. The plurality of first ground vias may be formed within the substrate and surrounding a plurality of signal vias. The plurality of first metal balls may be disposed on the substrate and electrically coupled to the plurality of first ground vias. One first metal ball may be electrically coupled to one first ground via. A first pitch associated with the plurality of first ground vias may be less than a second pitch associated with the plurality of first metal balls.

### BRIEF DESCRIPTION OF THE DRAWINGS

The accompanying drawings are included to provide a further understanding of the disclosure and are incorporated in and constitute a part of the present disclosure. The drawings illustrate implementations of the disclosure and, together with the description, serve to explain the principles of the disclosure. It is appreciable that the drawings are not necessarily in scale as some components may be shown to be out of proportion than the size in actual implementation in order to clearly illustrate the concept of the present disclosure.
FIG. 1 is a diagram depicting an example scenario under schemes in accordance with implementations of the present disclosure.
FIG. 2A is a top view of a device in accordance with implementations of the present disclosure.
FIG. 2B is a perspective view of a device in accordance with implementations of the present disclosure.
FIG. 3A is a top view of a device in accordance with implementations of the present disclosure.
FIG. 3B is a perspective view of a device in accordance with implementations of the present disclosure.
FIG. 4A is a top view of a device in accordance with implementations of the present disclosure.
FIG. 4B is a perspective view of a device in accordance with implementations of the present disclosure.

### DETAILED DESCRIPTION OF PREFERRED IMPLEMENTATIONS

The following description is provided in connection with accompanying drawings to illustrate example embodiments of the present disclosure. These embodiments are presented for explanatory purposes only and are not intended to limit the scope of the disclosure. Various features and elements described herein may be rearranged, omitted, or combined in different ways to form other embodiments.

Phrases such as "an embodiment," "one embodiment," "certain embodiments," or "example embodiments" refer to specific implementations that may include particular features or configurations. These expressions do not necessarily refer to the same embodiment in each instance, and the inclusion of such phrases should not be interpreted as limiting the disclosure to only those forms.

To enhance clarity and enable full understanding of the disclosed structures, certain configurations and steps are described in detail below. However, components or methods that are well understood by those skilled in the art may be simplified or omitted for brevity. The present disclosure is not restricted to the illustrated examples, and its full scope is defined solely by the appended claims.

Examples provided herein describe physical layouts and structural relationships between components such as vias, conductors, and connection terminals. These examples are intended to illustrate the principles of the disclosure, not to restrict the dimensional values, material choices, or fabrication sequences unless explicitly stated. Features shown in the figures may be stylized, not drawn to scale, and may exclude layers or components that are not essential to the description.

Directional terms such as "top," "bottom," "vertical," "horizontal," "above," and "below" are used merely to describe relative positions or orientations in the figures. Such terminology is not intended to impose any strict spatial or gravitational orientation, and the disclosed structures may be implemented in any orientation suitable for a given application or manufacturing method.

### Overview

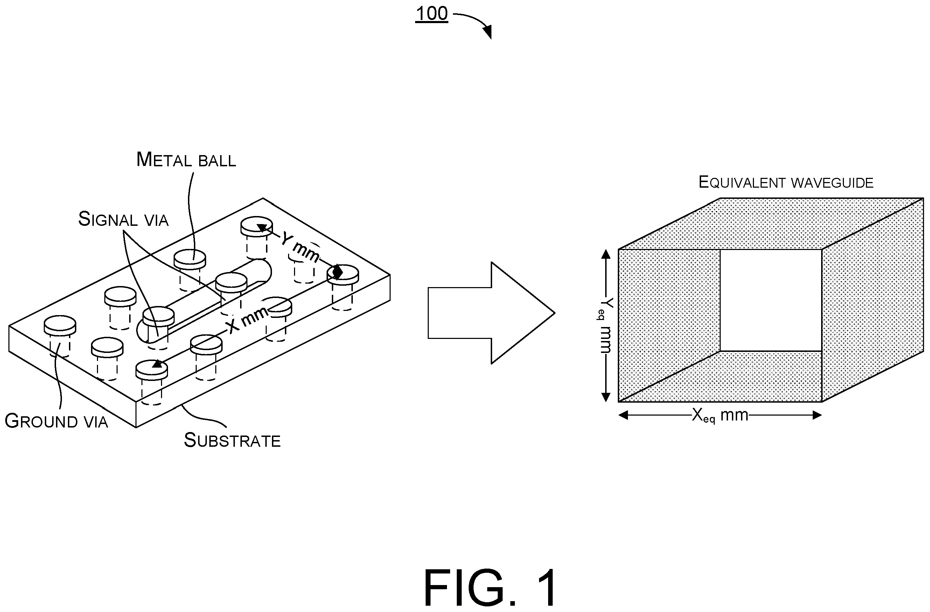

In some scenarios, the cut-off frequency of a higher-order mode may depend on the dielectric constant and the effective width of a Substrate Integrated Waveguide (SIW) formed by ground vias. FIG. 1 illustrates an example scenario 100 under schemes in accordance with implementations of the present disclosure. For example, within a substrate, ground vias are arranged to surround signal vias. Metal balls are coupled to both the ground vias and the signal vias. The area occupied by the metal balls has dimensions of approximately X millimeters by Y millimeters. Based on certain physical calculations, an equivalent waveguide having dimensions of X_{eq} millimeters by Y_{eq} millimeters is derived. A smaller equivalent waveguide size corresponds to a higher cut-off frequency, thereby enabling a higher usable frequency range and greater bandwidth for reliable high-speed signal transmission. Accordingly, the equivalent waveguide may be configured to be as small as necessary to meet high-frequency performance requirements.

Regarding the present disclosure, a device may include a substrate, a plurality of first ground vias and a plurality of first metal balls. The plurality of first ground vias may be formed within the substrate and surrounding a plurality of signal vias. The plurality of first metal balls may be disposed on the substrate and electrically coupled to the plurality of first ground vias. In some cases, one first metal ball is electrically coupled to one first ground via.

In some implementations, in the structure of the device, at least one of the plurality of first ground vias may be laterally offset from at least one corresponding first metal ball along a direction orthogonal to the substrate. In other words, one first ground via may be misaligned with the corresponding first metal ball.

In some implementations, the first pitch associated with the plurality of first ground vias may be less than a second pitch associated with the plurality of first metal balls, indicating that the spatial distribution of the plurality of first ground vias may be denser than that of the first metal balls.

Accordingly, compared to a structure in which the metal balls are aligned with the corresponding vias, the described arrangement (with a tighter ground via pitch) may effectively reduce the equivalent waveguide width, thereby increasing the cut-off frequency threshold and mitigating the risk of higher-order mode excitation and associated signal degradation.

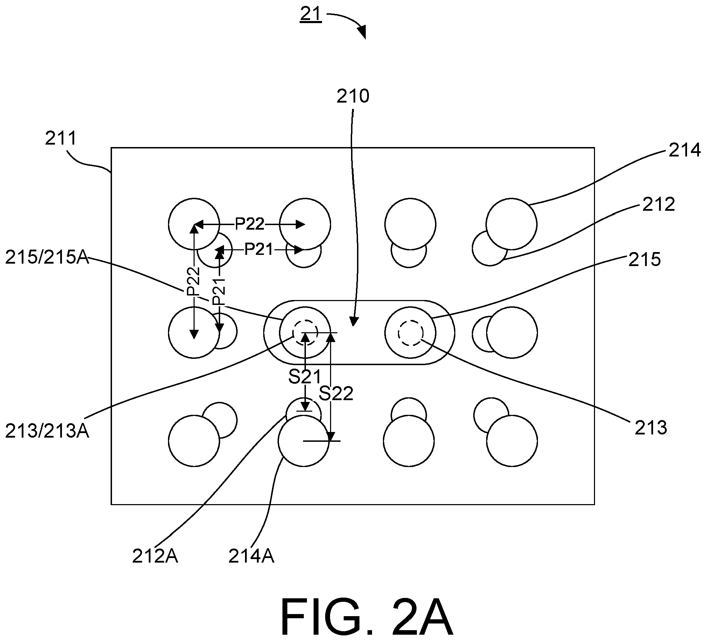

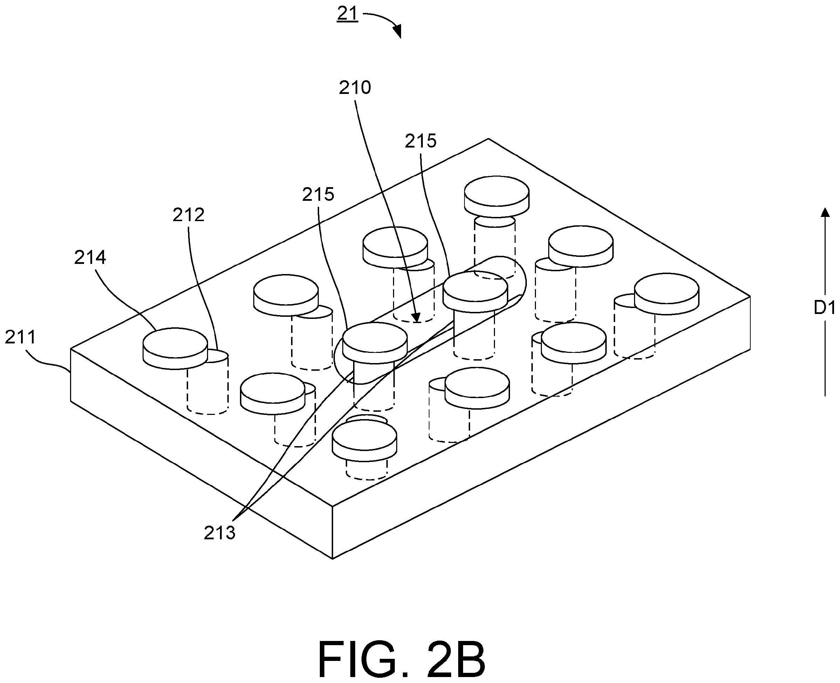

FIG. 2A illustrates a top view of a device 21 in accordance with implementations of the present disclosure. FIG. 2B illustrates a perspective view of the device 21 in accordance with implementations of the present disclosure. In particular, the device 21 may include a substrate 211, a plurality of first ground vias 212, a plurality of signal vias 213, a plurality of first metal balls 214, and a plurality of second metal balls 215. It should be noted that, in FIGs. 2A and 2B, one first ground via 212 and one first metal ball 214 are labeled for ease of understanding. However, this is not intended to limit the scope of the present disclosure. Those skilled in the art will readily recognize the remaining first ground vias and first metal balls shown in FIGs. 2A and 2B.

In some implementations, the substrate 211 may have a hollow portion 210 for accommodating the plurality of signal vias 213. The plurality of first ground vias 212 may be formed within the substrate 211. The plurality of first ground vias 212 may be arranged to surround or encircle the plurality of signal vias 213. The plurality of first metal balls 214 may be disposed on the substrate 211. The plurality of second metal balls 215 may be disposed on the plurality of signal vias 213. It should be noted that, in FIGs. 2A and 2B, signal traces for connecting the plurality of signal vias 213 are omitted for ease of understanding. However, this is not intended to limit the scope of the present disclosure. Those skilled in the art will readily understand how such traces may be implemented based on the disclosed structures.

In some implementations, the plurality of first metal balls 214 may be electrically coupled to the plurality of first ground vias 212. Each first metal ball 214 may be electrically coupled to a corresponding first ground via 212 in a one-to-one relationship. The plurality of first metal balls 214 may be directly connected to the plurality of first ground vias 212.

In some implementations, the plurality of second metal balls 215 may be electrically coupled to the plurality of signal vias 213. Each second metal ball 215 may be electrically coupled to a corresponding signal via 213 in a one-to-one relationship. The plurality of second metal balls 215 may be directly connected to the plurality of signal vias 213.

In some implementations, a part of the first ground vias 212 may be laterally offset from a corresponding part of the first metal balls 214 along a direction D1 orthogonal to the substrate 211. In other words, the part of the plurality of first ground vias 212 may be misaligned with the part of corresponding first metal balls 214. In some cases, the part of the first ground vias 212 may include all the first ground vias 212, and the corresponding part of the first metal balls 214 may include all the first metal balls 214.

More specifically, regarding the part of the first ground vias 212, each first ground via 212 may be laterally offset from the corresponding first metal balls 214. In other words, each of the part of the plurality of first ground vias 212 may be misaligned with the corresponding first metal ball 214.

In some implementations, a first pitch P21 between two adjacent first ground vias 212 may be arranged to be less than a second pitch P22 between two adjacent first metal balls 214 corresponding to the two adjacent first ground vias 212. In addition, a first center-to-center distance S21 between a specific first ground via 212A and a specific signal via 213A may be less than a second center-to-center distance S22 between a specific first metal ball 214A and a specific second metal ball 215A. The specific signal via 213A may be adjacent to the first ground via 212A. The specific first metal ball 214A may correspond to the specific first ground via 212A. The specific second metal ball 215A may correspond to the specific signal via 213A.

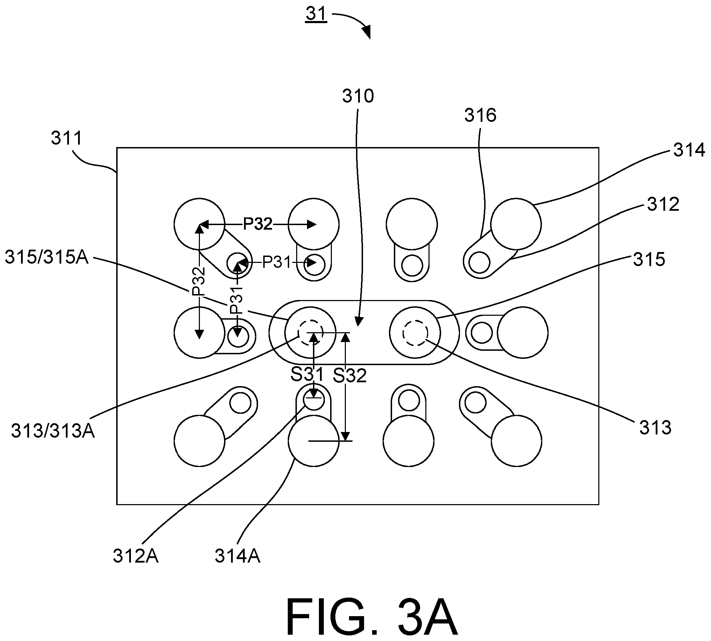

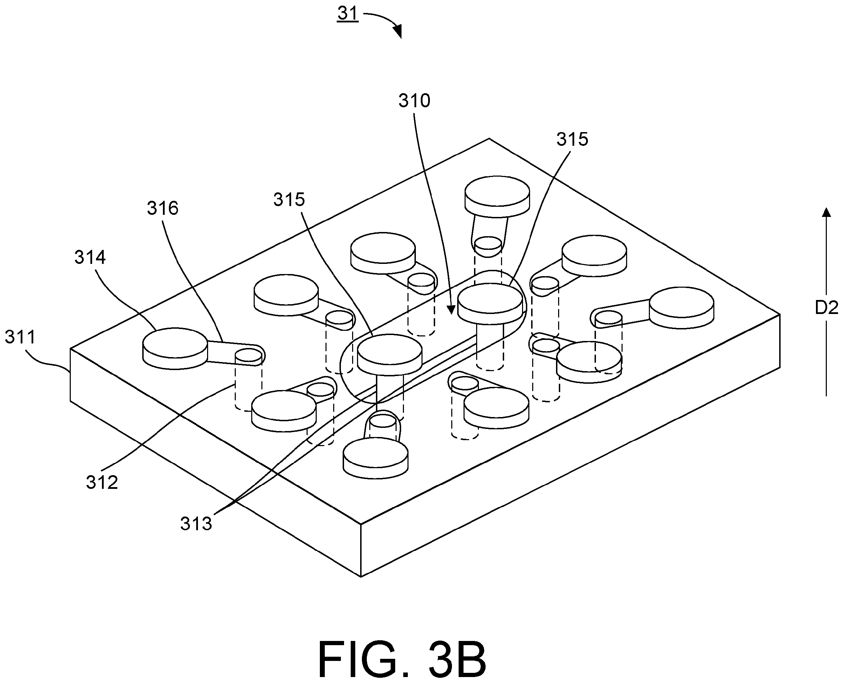

FIG. 3A illustrates a top view of a device 31 in accordance with implementations of the present disclosure. FIG. 3B illustrates a perspective view of the device 31 in accordance with implementations of the present disclosure. In particular, the device 31 may include a substrate 311, a plurality of first ground vias 312, a plurality of signal vias 313, a plurality of first metal balls 314, a plurality of second metal balls 315 and a plurality of metal lines 316. It should be noted that, in FIGs. 3A and 3B, one first ground via 312, one first metal ball 314, and one metal line 316 are labeled for ease of understanding. However, this is not intended to limit the scope of the present disclosure. Those skilled in the art will readily recognize the remaining first ground vias, first metal balls and metal lines shown in FIGs. 3A and 3B.

In some implementations, the substrate 311 may have a hollow portion 310 for accommodating the plurality of signal vias 313. The plurality of first ground vias 312 may be formed within the substrate 311. The plurality of first ground vias 312 may be arranged to surround or encircle the plurality of signal vias 313. The plurality of first metal balls 314 may be disposed on the substrate 311. The plurality of second metal balls 315 may be disposed on the plurality of signal vias 313. It should be noted that, in FIGs. 3A and 3B, signal traces for connecting the plurality of signal vias 313 are omitted for ease of understanding. However, this is not intended to limit the scope of the present disclosure. Those skilled in the art will readily understand how such traces may be implemented based on the disclosed structures.

In some implementations, the plurality of metal lines 316 may connect the plurality of first ground vias 312 to the plurality of first metal balls 314. The plurality of first metal balls 314 may be electrically coupled to the plurality of first ground vias 312 via the plurality of metal lines 316. Each first metal ball 314 may be electrically coupled to a corresponding first ground via 312 by a corresponding metal line 316 in a one-to-one relationship.

In some implementations, the plurality of second metal balls 315 may be electrically coupled to the plurality of signal vias 313. Each second metal ball 315 may be electrically coupled to a corresponding signal via 313 in a one-to-one relationship. The plurality of second metal balls 315 may be directly connected to the plurality of signal vias 313.

In some implementations, the first ground vias 312 may be laterally offset from corresponding first metal balls 314 along a direction D2 orthogonal to the substrate 311. In other words, the first ground vias 312 may be misaligned with the corresponding first metal balls 314. More specifically, each first ground via 312 may be laterally offset from the corresponding first metal ball 314. In other words, each first ground via 312 may be misaligned with the corresponding first metal ball 314.

In some implementations, a first pitch P31 associated with the plurality of first ground vias 312 may be arranged to be less than a second pitch P32 associated with the plurality of first metal balls 314. More specifically, the first pitch P31 between two adjacent first ground vias 312 may be arranged to be less than the second pitch P32 between two adjacent first metal balls 314 corresponding to the two adjacent first ground vias 312. In addition, a first center-to-center distance S31 between a specific first ground via 312A and a specific signal via 313A may be less than a second center-to-center distance S32 between a specific first metal ball 314A and a specific second metal ball 315A. The specific signal via 313A may be adjacent to the first ground via 312A. The specific first metal ball 314A may correspond to the specific first ground via 312A. The specific second metal ball 315A may correspond to the specific signal via 313A.

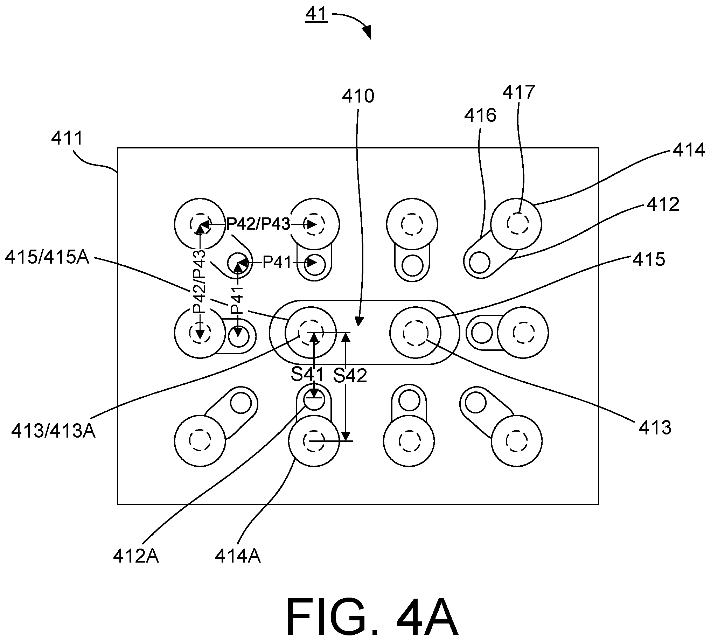

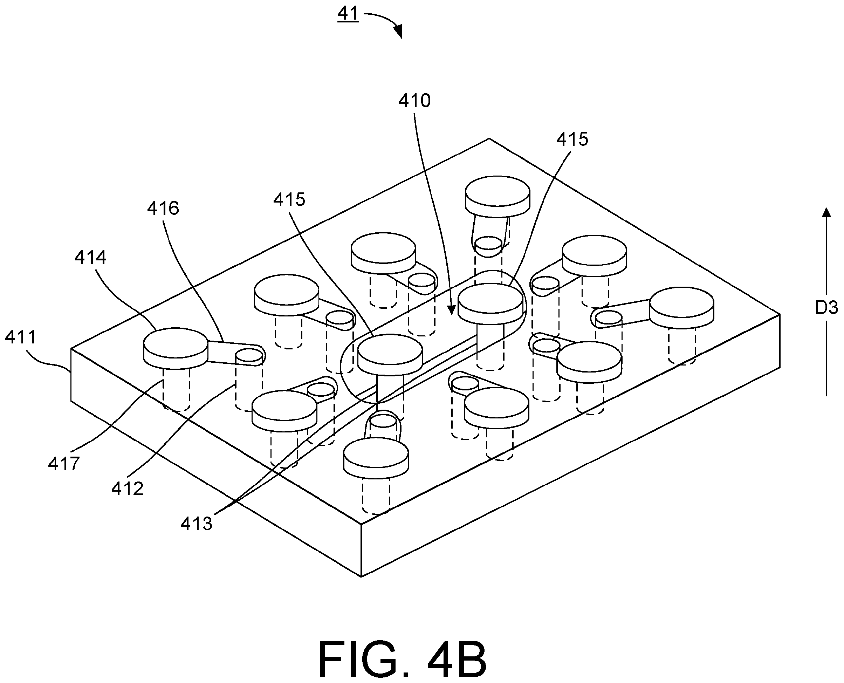

FIG. 4A illustrates a top view of a device 41 in accordance with implementations of the present disclosure. FIG. 4B illustrates a perspective view of the device 41 in accordance with implementations of the present disclosure. In particular, the device 41 may include a substrate 411, a plurality of first ground vias 412, a plurality of signal vias 413, a plurality of first metal balls 414, a plurality of second metal balls 415, a plurality of metal lines 416, and a plurality of second ground vias 417. It should be noted that, in FIGs. 4A and 4B, one first ground via 412, one first metal ball 414, one metal line 416, and one second ground via 417 are labeled for ease of understanding. However, this is not intended to limit the scope of the present disclosure. Those skilled in the art will readily recognize the remaining first ground vias, first metal balls, metal lines and second ground vias shown in FIGs. 4A and 4B.

In some implementations, the substrate 411 may have a hollow portion 410 for accommodating the plurality of signal vias 413. The plurality of first ground vias 412 and the plurality of second ground vias 417 may be formed within the substrate 411. The plurality of first ground vias 412 may be arranged to surround or encircle the plurality of signal vias 413. The plurality of second ground vias 417 may be arranged to surround or encircle the plurality of first ground vias 412 and the plurality of signal vias 413. The plurality of first metal balls 414 may be disposed on the substrate 411. The plurality of second metal balls 415 may be disposed on the plurality of signal vias 413. It should be noted that, in FIGs. 4A and 4B, signal traces for connecting the plurality of signal vias 413 are omitted for ease of understanding. However, this is not intended to limit the scope of the present disclosure. Those skilled in the art will readily understand how such traces may be implemented based on the disclosed structures.

In some implementations, the plurality of metal lines 416 may connect the plurality of first ground vias 412 to the plurality of first metal balls 414. The plurality of first metal balls 414 may be electrically coupled to the plurality of first ground vias 412 via the plurality of metal lines 416. Each first metal ball 414 may be electrically coupled to a corresponding first ground via 412 by a corresponding metal line 416 in a one-to-one relationship. The plurality of first metal balls 414 may be electrically coupled to the plurality of second ground vias 417 by direct contact. Each first metal ball 414 may be directly connected to a corresponding second ground via 417 in a one-to-one relationship.

In some implementations, the plurality of second metal balls 415 may be electrically coupled to the plurality of signal vias 413. Each second metal ball 415 may be electrically coupled to a corresponding signal via 413 in a one-to-one relationship. The plurality of second metal balls 415 may be directly connected to the plurality of signal vias 413.

In some implementations, the first ground vias 412 may be laterally offset from corresponding first metal balls 414 along a direction D3 orthogonal to the substrate 411. In other words, the first ground vias 412 may be misaligned with the corresponding first metal balls 414. More specifically, each first ground via 412 may be laterally offset from the corresponding first metal ball 414. In other words, each first ground via 412 may be misaligned with the corresponding first metal ball 414.

In some implementations, a first pitch P41 associated with the plurality of first ground vias 412 may be arranged to be less than a second pitch P42 associated with the plurality of first metal balls 414. More specifically, the first pitch P41 between two adjacent first ground vias 412 may be arranged to be less than the second pitch P42 between two adjacent first metal balls 414 corresponding to the two adjacent first ground vias 412. The first pitch P41 may be arranged to be less than a third pitch P43 associated with the plurality of second ground vias 417. More specifically, the first pitch P41 between two adjacent first ground vias 412 may be arranged to be less than the third pitch P43 between two adjacent second ground vias 417.

In addition, a first center-to-center distance S41 between a specific first ground via 412A and a specific signal via 413A may be less than a second center-to-center distance S42 between a specific first metal ball 414A and a specific second metal ball 415A. The specific signal via 413A may be adjacent to the first ground via 412A. The specific first metal ball 414A may correspond to the specific first ground via 412A. The specific second metal ball 415A may correspond to the specific signal via 413A.

Accordingly, in comparison with a structure in which the metal balls are aligned (e.g., vertically aligned) with corresponding vias, the arrangements of the devices 21, 31, and/or 41 (featuring a reduced pitch among the ground vias) may effectively decrease the equivalent waveguide width. As a result, the cut-off frequency threshold may be increased, thereby reducing the likelihood of higher-order mode excitation and improving signal integrity under high-frequency operating conditions.

In some implementations, the substrates 211, 311, and/or 411 may be a Printed Circuit Board (PCB). The PCB may include multiple stacked layers configured for different electrical and structural purposes, including dielectric layers, signal traces, power planes, and/or ground planes. Elements associated with the substrates 211, 311, and/or 411 may be on the order of millimeters. In particular, the pitches, vias, metal balls, and/or metal lines may be on the order of millimeters. For example, the pitch between two metal balls may be 1 millimeter, while the pitch between two first ground vias may be 0.75 millimeters, which is smaller than the pitch between the metal balls. In some implementations, the metal balls of the devices 21, 31, and/or 41 may be implemented as a Ball Grid Array (BGA). The metal balls may include solder balls. However, this is not intended to limit the scope of the present disclosure. Those skilled in the art will readily appreciate that the structural concepts disclosed herein may be applied to various implementations where reduction of the equivalent waveguide width is desired.

### Additional Notes

While the foregoing embodiments have been described in detail to illustrate the principles of the disclosure, it should be understood that various modifications, substitutions, or rearrangements may be made without departing from the intended scope of the invention as defined by the appended claims. For instance, structural features, layout strategies, or fabrication procedures described herein may be implemented using alternative techniques or combined in different ways.

The scope of the present disclosure is not limited to the particular examples or processes discussed above. A person skilled in the art may apply equivalent configurations, fabrication methods, or structural arrangements that achieve substantially similar purposes or technical effects. Accordingly, such modifications or alternatives are intended to be included within the scope of protection defined by the claims.

Further, with respect to the use of substantially any plural and/or singular terms herein, those having skill in the art can translate from the plural to the singular and/or from the singular to the plural as is appropriate to the context and/or application. The various singular/plural permutations may be expressly set forth herein for sake of clarity.

Moreover, it will be understood by those skilled in the art that, in general, terms used herein, and especially in the appended claims, e.g., bodies of the appended claims, are generally intended as "open" terms, e.g., the term "including" should be interpreted as "including but not limited to," the term "having" should be interpreted as "having at least," the term "includes" should be interpreted as "includes but is not limited to," etc. It will be further understood by those within the art that if a specific number of an introduced claim recitation is intended, such an intent will be explicitly recited in the claim, and in the absence of such recitation no such intent is present. For example, as an aid to understanding, the following appended claims may contain usage of the introductory phrases "at least one" and "one or more" to introduce claim recitations. However, the use of such phrases should not be construed to imply that the introduction of a claim recitation by the indefinite articles "a" or "an" limits any particular claim containing such introduced claim recitation to implementations containing only one such recitation, even when the same claim includes the introductory phrases "one or more" or "at least one" and indefinite articles such as "a" or "an," e.g., "a" and/or "an" should be interpreted to mean "at least one" or "one or more;" the same holds true for the use of definite articles used to introduce claim recitations. In addition, even if a specific number of an introduced claim recitation is explicitly recited, those skilled in the art will recognize that such recitation should be interpreted to mean at least the recited number, e.g., the bare recitation of "two recitations," without other modifiers, means at least two recitations, or two or more recitations. Furthermore, in those instances where a convention analogous to "at least one of A, B, and C, etc." is used, in general such a construction is intended in the sense one having skill in the art would understand the convention, e.g., "a system having at least one of A, B, and C" would include but not be limited to systems that have A alone, B alone, C alone, A and B together, A and C together, B and C together, and/or A, B, and C together, etc. In those instances where a convention analogous to "at least one of A, B, or C, etc." is used, in general such a construction is intended in the sense one having skill in the art would understand the convention, e.g., "a system having at least one of A, B, or C" would include but not be limited to systems that have A alone, B alone, C alone, A and B together, A and C together, B and C together, and/or A, B, and C together, etc. It will be further understood by those within the art that virtually any disjunctive word and/or phrase presenting two or more alternative terms, whether in the description, claims, or drawings, should be understood to contemplate the possibilities of including one of the terms, either of the terms, or both terms. For example, the phrase "A or B" will be understood to include the possibilities of "A" or "B" or "A and B."

From the foregoing, it will be appreciated that various implementations of the present disclosure have been described herein for purposes of illustration, and that various modifications may be made without departing from the scope and spirit of the present disclosure. Accordingly, the various implementations disclosed herein are not intended to be limiting, with the true scope and spirit being indicated by the following claims.

Various embodiments are set out in the following numbered clauses.

Clause 1. A device, comprising: a substrate; a plurality of first ground vias, formed within the substrate and surrounding a plurality of signal vias; and a plurality of first metal balls, disposed on the substrate and electrically coupled to the plurality of first ground vias, wherein one first metal ball is electrically coupled to one first ground via, wherein a part of the plurality of first ground vias is laterally offset from a corresponding part of the plurality of first metal balls along a direction orthogonal to the substrate.

Clause 2. The device of Clause 1, further comprising: a plurality of metal lines, connected to the plurality of first metal balls and the plurality of first ground vias.

Clause 3. The device of Clause 1, wherein the plurality of first metal balls are directly connected to the plurality of first ground vias.

Clause 4. The device of Clause 1, wherein the plurality of first ground vias are laterally offset from the plurality of first metal balls along the direction orthogonal to the substrate.

Clause 5. The device of Clause 4, wherein a first pitch between two adjacent first ground vias is less than a second pitch between two adjacent first metal balls corresponding to the two adjacent first ground vias.

Clause 6. The device of Clause 4, wherein a first center-to-center distance between a specific first ground via and a specific signal via adjacent thereto is less than a second center-to-center distance between a specific first metal ball corresponding to the specific first ground via and a specific second metal ball corresponding to the specific signal via.

Clause 7. The device of Clause 1, further comprising: a plurality of second ground vias, formed within the substrate and surrounding the plurality of signal vias and the plurality of first ground vias, wherein the plurality of first metal balls are electrically connected to the plurality of second ground vias, and wherein one first metal ball is electrically connected to one second ground via.

Clause 8. The device of Clause 7, wherein a first pitch between two adjacent first ground vias is less than a second pitch between two adjacent second ground vias.

Clause 9. The device of Clause 7, wherein a first center-to-center distance between a specific first ground via and a specific signal via adjacent thereto is less than a second center-to-center distance between a specific second ground via and another specific signal via adjacent thereto.

Clause 10.The device of Clause 1, wherein a pitch of the plurality of the first ground vias is on the order of millimeters.

Clause 11.A device, comprising: a substrate; a plurality of first ground vias, formed within the substrate and surrounding a plurality of signal vias; and a plurality of first metal balls, disposed on the substrate and electrically coupled to the plurality of first ground vias, wherein one first metal ball is electrically coupled to one first ground via, wherein a first pitch associated with the plurality of first ground vias is less than a second pitch associated with the plurality of first metal balls.

Clause 12.The device of Clause 11, further comprising: a plurality of metal lines, connected to the plurality of first metal balls and the plurality of first ground vias.

Clause 13.The device of Clause 11, wherein the plurality of first metal balls are directly connected to the plurality of first ground vias.

Clause 14.The device of Clause 11, wherein a part of the plurality of first ground vias is misaligned with a part of corresponding first metal balls.

Clause 15.The device of Clause 14, wherein a first center-to-center distance between a specific first ground via and a specific signal via adjacent thereto is less than a second center-to-center distance between a specific first metal ball corresponding to the specific first ground via and a specific second metal ball corresponding to the specific signal via.

Clause 16.The device of Clause 11, further comprising: a plurality of second ground vias, formed within the substrate and surrounding the plurality of signal vias and the plurality of first ground vias, wherein the plurality of first metal balls are electrically connected to the plurality of second ground vias, and wherein one first metal ball is electrically connected to one second ground via.

Clause 17.The device of Clause 16, wherein the first pitch associated with the plurality of first ground vias is less than a third pitch associated with the plurality of second ground vias.

Clause 18.The device of Clause 16, wherein a first center-to-center distance between a specific first ground via and a specific signal via adjacent thereto is less than a second center-to-center distance between a specific second ground via and another specific signal via adjacent thereto.

Clause 19.The device of Clause 11, wherein the substrate is a Printed Circuit Board (PCB).

Clause 20.The device of Clause 11, wherein the first metal balls include a Ball Grid Array (BGA).

## Claims

1. A device (21, 31, 41), comprising:
a substrate (211, 311, 411);
a plurality of first ground vias (212, 312, 412), formed within the substrate (211, 311, 411) and surrounding a plurality of signal vias (213, 313, 413); and a plurality of first metal balls (214, 314, 414), disposed on the substrate (211, 311, 411) and electrically coupled to the plurality of first ground vias (212, 312, 412), wherein one first metal ball (214, 314, 414) is electrically coupled to one first ground via (212, 312, 412),
wherein a part of the plurality of first ground vias (212, 312, 412) is laterally offset from a corresponding part of the plurality of first metal balls (214, 314, 414) along a direction orthogonal to the substrate (211, 311, 411).

2. The device (21, 31, 41) of Claim 1, further comprising:
a plurality of metal lines (316, 416), connected to the plurality of first metal balls (214, 314, 414) and the plurality of first ground vias (212, 312, 412).

3. The device (21, 31, 41) of Claim 1, wherein the plurality of first metal balls (214, 314, 414) are directly connected to the plurality of first ground vias (212, 312, 412).

4. The device (21, 31, 41) of Claim 1, wherein the plurality of first ground vias (212, 312, 412) are laterally offset from the plurality of first metal balls (214, 314, 414) along the direction orthogonal to the substrate (211, 311, 411).

5. The device (21, 31, 41) of Claim 4, wherein a first pitch between two adjacent first ground vias (212, 312, 412) is less than a second pitch between two adjacent first metal balls (214, 314, 414) corresponding to the two adjacent first ground vias (212, 312, 412).

6. The device (21, 31, 41) of Claim 4, wherein a first center-to-center distance between a specific first ground via (212A, 312A, 412A) and a specific signal via (213A, 313A, 413A) adjacent thereto is less than a second center-to-center distance between a specific first metal ball (214A, 314A, 414A) corresponding to the specific first ground via (212A, 312A, 412A) and a specific second metal ball (215A, 315A, 415A) corresponding to the specific signal via (213A, 313A, 413A).

7. The device (41) of Claim 1, further comprising:
a plurality of second ground vias (417), formed within the substrate (411) and surrounding the plurality of signal vias (413) and the plurality of first ground vias (412),
wherein the plurality of first metal balls (414) are electrically connected to the plurality of second ground vias (417), and wherein one first metal ball (414) is electrically connected to one second ground via (417).

8. The device (41) of Claim 7, wherein a first pitch between two adjacent first ground vias (412) is less than a second pitch between two adjacent second ground vias (417).

9. The device (41) of Claim 7, wherein a first center-to-center distance between a specific first ground via (412A) and a specific signal via (413A) adjacent thereto is less than a second center-to-center distance between a specific second ground via (417) and another specific signal via (413A) adjacent thereto.

10. The device (21, 31, 41) of Claim 1, wherein a pitch of the plurality of the first ground vias (212, 312, 412) is on the order of millimeters.

11. The device (21, 31, 41) of claim 1, wherein a first pitch associated with the plurality of first ground vias (212, 312, 412) is less than a second pitch associated with the plurality of first metal balls (214, 314, 414).

12. The device (21, 31, 41) of Claim 11, wherein a part of the plurality of first ground vias (212, 312, 412) is misaligned with a part of corresponding first metal balls (214, 314, 414).

13. The device (21, 31, 41) of Claim 12, wherein a first center-to-center distance between a specific first ground via (212A, 312A, 412A) and a specific signal via (213A, 313A, 413A) adjacent thereto is less than a second center-to-center distance between a specific first metal ball (214A, 314A, 414A) corresponding to the specific first ground via (212A, 312A, 412A) and a specific second metal ball (215A, 315A, 415A) corresponding to the specific signal via (213A, 313A, 413A).

14. The device (41) of Claim 11, further comprising:
a plurality of second ground vias (417), formed within the substrate (411) and surrounding the plurality of signal vias (413) and the plurality of first ground vias (412),
wherein the plurality of first metal balls (414) are electrically connected to the plurality of second ground vias (417), and wherein one first metal ball (414) is electrically connected to one second ground via (417).

15. The device (41) of Claim 14, wherein the first pitch associated with the plurality of first ground vias (412) is less than a third pitch associated with the plurality of second ground vias (417).
